# FASCICULE DE BREVET EUROPEEN

(11) **EP 3 074 231 B1**
(45) Date de publication et mention de la délivrance du brevet: **24.03.2021**
(21) Numéro de dépôt: 14802649.5
(22) Date de dépôt: 24.11.2014
(51) Int. Cl.: C09D 11/52, C09D 11/037, C09D 11/08

(54) **ENCRE A BASE DE NANOPARTICULES D'ARGENT**
TINTE BASIEREND AUF SILBERNANOPARTIKELN
INK COMPOSITION BASED ON SILVER NANOPARTICLES

(30) Priorité: 27.11.2013 FR 1302745
(43) Date de publication de la demande: 05.10.2016
(73) Titulaire: Genes'Ink SA, 13790 Rousset (FR)
(72) Inventeur: KAUFFMANN, Louis Dominique, F-83260 La Crau (FR); VERSINI, Corinne, F-13100 Aix en Provence (FR); DELPONT, Nicolas, F-13770 Venelles (FR)
(74) Mandataire: King, Alex
(86) Numéro de dépôt international: PCT/EP2014/075415
(87) Numéro de publication internationale: WO 2015/078818

(56) Documents cités:
- EP-A1- 2 119 747
- EP-A1- 2 236 565
- EP-A2- 2 371 887
- WO-A2-2010/067965
- WO-A2-2010/101418
- US-B1- 7 977 240

## Description

La présente invention a pour objet des formulations d'encre à base de nanoparticules d'argent. En particulier, la présente invention concerne des formulations d'encre à base de nanoparticules d'argent, les dites encres étant stables et à conductivité améliorée.

Plus particulièrement, la présente invention se rapporte au domaine des encres à base de nanoparticules conductrices adaptées pour la sérigraphie.

Les encres à base de nanoparticules conductrices selon la présente invention peuvent être imprimées sur tous types de supports. On citera à titre d'exemple les supports suivants : polymères et dérivés de polymères, matériaux composites, matériaux organiques, matériaux inorganiques.

Les encres à base de nanoparticules conductrices selon la présente invention présentent de nombreux avantages parmi lesquels nous citerons à titre d'exemples non limitatifs :
- une stabilité dans le temps supérieure aux encres actuelles ;
- une non-toxicité des solvants et des nanoparticules ;
- une conservation des propriétés intrinsèques des nanoparticules ; et, en particulier,
- une conductivité améliorée pour des températures de recuit généralement comprises entre 200°C et 300°C.

La présente invention se rapporte également à une méthode de préparation améliorée des dites encres ; enfin, la présente invention se rapporte aussi à l'utilisation des dites encres dans le domaine de la sérigraphie.

A la vue de la littérature de ces dernières années, les nanocristaux colloïdaux conducteurs ont reçu beaucoup d'attention grâce à leurs nouvelles propriétés optoélectroniques, photovoltaïques et catalytiques. Cela les rend particulièrement intéressants pour de futures applications dans le domaine de la nanoélectronique, des cellules solaires, des capteurs et du biomédical.

Le développement de nanoparticules conductrices permet de recourir à de nouvelles mises en œuvre et d'entrevoir une multitude de nouvelles applications. Les nanoparticules possèdent un rapport surface / volume très important et la substitution de leur surface par des tensioactifs entraîne le changement de certaines propriétés, notamment optiques, et la possibilité de les disperser.

Leurs faibles dimensions peuvent amener dans certains cas des effets de confinement quantique. Le terme de nanoparticules est employé lorsqu'au moins une des dimensions de la particule est inférieure à 100 nm. Les nanoparticules peuvent être des billes (de 1 à 100 nm), des bâtonnets (L < 200 à 300 nm), des fils (quelques centaines de nanomètres voire quelques microns), des disques, des étoiles, des pyramides, des tétrapodes, des cubes ou des cristaux lorsqu'ils n'ont pas de forme prédéfinie.

EP2371887 A2 concerne un matériau polymérique comprenant un polymère et des nanoparticules d'argent dispersées dans le polymère, ledit matériau étant particulièrement adapté pour être utilisé comme une électrode. Plus particulièrement, les matériaux polymériques de EP2371887 A2 sont préparés par mélange de dispersion aqueuse de nanoparticules d'argent (83% en poids d'eau) avec une dispersion aqueuse de polyuréthane (50% en poids d'eau) ainsi qu'un mélange d'additif comprenant plus de 98% en poids d'eau.

WO2010101418 A2 revendique des compositions de pâte conductrice contenant plus de 40% en poids de particules de métal en forme de plaque de dimensions de l'ordre du micromètre et moins de 20% en poids de nanoparticules d'argent ; ces compositions peuvent également comprendre des nanoparticules de métal tel que le cuivre ou le palladium.

WO201067965 A2 concerne une encre conductrice de l'électricité dont la composition comprend une dispersion, des nanoparticules d'argent et des flocons de cuivre revêtus d'argent, les dits flocons ayant une longueur d'axe principal de 2 à 12 microns.

EP2236565 A1 concerne une composition qui comprend des nanoparticules d'argent stabilisées, un agent gélifiant et une cire facultative qui sont des agents de changement de phase dont la caractéristique est d'augmenter d'un facteur minimum de 100 la viscosité de la composition de nanoparticules d'argent.

EP2119747 A1 concerne des compositions imprimables sous forme de pâte de viscosité élevée comprenant une solution aqueuse de nanoparticules et plus de 50 % en poids de poudre d'argent.

US7977240 B1 concerne un procédé de formation d'une couche d'interconnexion métallique, comprenant la formation d'une couche comprenant du silicium et/ou du germanium sur un substrat ; et le dépôt d'une composition d'encre métallique sur cette couche, ladite composition d'encre métallique comprenant un métal en vrac et une source de métal de transition formant un siliciure.

Plusieurs procédés ont été élaborés afin de synthétiser des nanoparticules conductrices. Parmi eux, on peut citer de façon non exhaustive :
- les procédés physiques :
   ▪ la déposition de vapeur chimique (aussi connue sous la dénomination « Chemical Vapor Deposition - CVD ») lorsqu'un substrat est exposé à des précurseurs chimiques volatilisés qui réagissent ou se décomposent sur sa surface. Ce procédé conduit généralement à la formation de nanoparticules dont la morphologie dépend des conditions utilisées ;
   ▪ l'évaporation thermique;
   ▪ l'épitaxie par jets moléculaires (aussi connue sous la dénomination « Molecular Beam Epitaxy ») lorsque des atomes qui vont constituer les nanoparticules sont bombardés à grande vitesse sur le substrat (où ils vont se fixer), sous la forme d'un flux gazeux ;
- les procédés chimiques ou physico-chimiques :
   ▪ la microémulsion ;
   ▪ l'impulsion laser en solution, lorsqu'une solution contenant un précurseur est irradiée par faisceau laser. Les nanoparticules se forment dans la solution le long du faisceau lumineux ;
   ▪ La synthèse par irradiation aux microondes ;
   ▪ La synthèse orientée assistée par des surfactants ;
   ▪ La synthèse sous ultrasons ;
   ▪ La synthèse électrochimique ;
   ▪ La synthèse organométallique ;
   ▪ La synthèse en milieu alcoolique.

Les synthèses physiques consomment plus de matières premières avec des pertes significatives. Elles nécessitent généralement du temps et des températures élevées ce qui les rendent peu attractives pour le passage à une production à l'échelle industrielle. Cela les rend non adaptées à certains substrats, par exemple les substrats souples. De plus, les synthèses s'effectuent directement sur les substrats dans des bâtis aux dimensions réduites. Ces modes de productions se révèlent relativement rigides et ne permettent pas de produire sur des substrats de grandes dimensions.

Les synthèses chimiques quant à elles possèdent de nombreux avantages. Le premier est de travailler en solution, les nanoparticules conductrices obtenues ainsi sont déjà dispersées dans un solvant ce qui en facilite le stockage et l'utilisation. Dans la plupart des cas, les nanoparticules ne sont pas fixées à un substrat en fin de synthèse ce qui amène plus de latitude dans leur utilisation. Cela ouvre la voie à l'emploi de substrats de différentes taille et de différentes natures. Ces méthodes permettent aussi un meilleur contrôle des matières premières mises enjeu et limitent des pertes. Un bon ajustement des paramètres de synthèse conduit à un bon contrôle de la synthèse et la cinétique de croissance des nanoparticules conductrices. Ceci permet de garantir une bonne reproductibilité entre les lots ainsi qu'un bon contrôle de la morphologie finale des nanoparticules. La capacité à produire rapidement et en grand quantité des nanoparticules par voie chimique tout en garantissant une certainement flexibilité au produit permet d'envisager une production à l'échelle industrielle. L'obtention des nanoparticules conductrices dispersées ouvre de nombreuses perspectives concernant leur customisation. Il est ainsi possible d'ajuster la nature des stabilisants présents à la surface des nanoparticules selon l'application visée. En effet, il existe différentes méthodes de dépôt en voie humide. Dans chaque cas, une attention particulière doit être portée aux propriétés physiques de l'encre telle que la tension de surface ou la viscosité. Les adjuvants employés lors de la formulation de l'encre à base de nanoparticules vont permettre de coller aux exigences de la méthode de dépôt. Mais les ligands de surface vont également impacter ces paramètres et leur choix s'avèrent décisif. Il est donc important d'avoir une vue d'ensemble de l'encre pour combiner tous les acteurs - nanoparticules, solvant, ligands et adjuvants- et obtenir un produit compatible avec les applications visées.

La présente invention a pour objectif de palier à un ou plusieurs inconvénients de l'art antérieur en fournissant une encre adaptée à la sérigraphie et comprenant de préférence une dispersion de nanoparticules d'argent stable et à forte concentration.

La présente invention concerne donc une encre dont la composition comprend au moins
1. un composé « a » consistant en des nanoparticules d'argent de forme sphéroïdale et/ou sphérique et de diamètres compris entre 1 et 50 nm,
2. un composé « e » consistant en un solvant, et
3. au moins un composé « f » et/ou « g » sélectionné parmi
   a. un composé « f » consistant en un agent modificateur de rhéologie de type polyurée dont la teneur est comprise entre 0,1 et 2 % en poids, et
   b. un composé « g » consistant en un agent modificateur de rhéologie de type cellulosique,
4. un composé « c » optionnel consistant en un agent dispersant,
5. un composé « d » optionnel consistant en un agent dispersant différent du composé « c »,
6. un composé optionnel « b » consistant en un solvant cyclooctane et/ou un solvant de type ester méthylique d'acides gras et/ou un solvant terpénique, et/ou un mélange de deux ou plusieurs des dits solvants, et
7. un solvant « X » optionnel additionnel de préférence sélectionné parmi les alcanes et/ou leurs mélanges,
   caractérisé en ce que les composés « a », « b », « c », « d », « e », « f », « g » et « X » constituent au moins 95% en poids de la composition d'encre, en ce qu'elle comprend une teneur en eau inférieure à 2 % en poids et en ce que la viscosité à 20°C de l'encre est comprise entre 100 et 1000 mPa.s.

La viscosité de l'encre à 20°C selon la présente invention est comprise entre 100 et 1 000 mPa.s, par exemple entre 100 et 800 mPa.s, par exemple entre 150 et 800 mPa.s.

La Demanderesse a découvert que la composition d'encre à base de nanoparticules d'argent selon la présente invention avec la combinaison des composés « e » et [ « f » et/ou « g » ] permettait l'obtention d'une encre aux propriétés améliorées, en particulier une stabilité améliorée ainsi qu'une conductivité améliorée dans une gamme de viscosités particulièrement adaptées pour des utilisations dans les domaines de la sérigraphie.

Le composé « a » selon la présente invention consiste donc en des nanoparticules d'argent. Selon une variante de réalisation de la présente invention, les objectifs de la présente invention sont particulièrement bien atteints lorsque le composé « a » est constitué de nanoparticules d'argent dont les dimensions sont comprises entre 1 et 50 nm, de préférence entre 2 et 20 nm. La taille des nanoparticules est définie comme étant le diamètre moyen des particules contenant de l'argent, à l'exclusion des stabilisants, tel que déterminé par exemple par microscopie électronique par transmission.

Selon la présente invention, les nanoparticules d'argent sont de forme sphéroïdale et/ou sphérique. Pour la présente invention et les revendications qui suivent, le terme « de forme sphéroïdale » signifie que la forme ressemble à celle d'une sphère mais elle n'est pas parfaitement ronde (« quai-sphérique »), par exemple une forme ellipsoïdale. La forme des nanoparticules est généralement identifiée au moyen de photographies prises par microscope. Ainsi, selon la présente invention, les nanoparticules ont des diamètres compris entre 1 et 50 nm, de préférence entre 2 et 20 nm.

Selon un mode d'exécution particulier de la présente invention, les nanoparticules d'argent ont été préalablement synthétisées par synthèse chimique. Toute synthèse chimique peut être préférentiellement utilisée dans le cadre de la présente invention. Dans un mode d'exécution préféré selon la présente invention les nanoparticules d'argent sont obtenues par une synthèse chimique qui utilise comme précurseur d'argent un sel d'argent organique ou inorganique. A titre d'exemple non limitatif, on citera l'acétate d'argent, le nitrate d'argent, le carbonate d'argent, le phosphate d'argent, le trifluorate d'argent, le chlorure d'argent, le perchlorate d'argent, seuls ou en mélange. Selon une variante préférée de la présente invention, le précurseur est de l'acétate d'argent.

Selon un mode d'exécution préféré de la présente invention, les nanoparticules d'argent sont donc synthétisées par synthèse chimique, par réduction du précurseur d'argent au moyen d'un agent réducteur en présence d'un agent dispersant, dénommé ci-après le composé « c » ; cette réduction peut s'effectuer en absence ou en présence d'un solvant (dénommé aussi par la suite le « solvant de synthèse »). Lorsque la synthèse est effectuée en absence de solvant, l'agent dispersant agit généralement à la fois en tant qu'agent dispersant et en tant que solvant du précurseur d'argent; un exemple particulier de synthèse de nanoparticules en milieu sans solvant et de préparation de la dispersion selon la présente invention est décrit à titre illustratif ci-après.

Préparation de la dispersion des nanoparticules dans le solvant « b » : dans un réacteur contenant de l'acétate d'argent, l'agent dispersant de synthèse (composé « c » ; par exemple la dodécylamine) est ajouté en excès et le mélange est agité moins de 30 minutes à 65°C. L'agent réducteur hydrazine est ensuite ajouté rapidement au mélange et l'ensemble est laissé sous agitation environ 60 minutes. Le mélange est traité par l'ajout de méthanol (ou de tout autre solvant approprié, par exemple un autre alcool monohydrique ayant de 2 à 3 atomes de carbone, par exemple de l'éthanol) et le surnageant est éliminé au cours de plusieurs lavages successifs (les nanoparticules d'argent ainsi formées restent donc à l'état de dispersion et au contact de liquide). Le solvant cyclooctane (composé « b ») est ajouté et le méthanol résiduel est évaporé. Le composé « d » (un agent dispersant différent du compose « b » utilisé ; par exemple une octylamine) est ensuite ajouté et le mélange est agité pendant 15 minutes à température ambiante. Les dispersions de nanoparticules d'argent ainsi obtenues sont utilisées directement pour la formulation des encres conductrices.

Le solvant de synthèse est de préférence un solvant organique choisi parmi la liste suivante d'hydrocarbures:
- les alcanes ayant de 5 à 20 atomes de carbone dont on citera à titre illustratif les Pentane (C5H12), Hexane (C6H14), Heptane (C7H16), Octane (C8H18), Nonane (C9H20), Décane (C10H22), Undécane (C11H24), Dodécane (C12H26), Tridécane (C13H28), Tétradécane (C14H30), Pentadécane (C15H32), Cétane (C16H34), Heptadécane (C17H36), Octadécane (C18H38), Nonadécane (C19H40), Eicosane (C20H42), cyclopentane (C5H10), cyclohexane (C6H12), méthylcyclohexane (C7H14), cycloheptane (C7H14), cyclooctane (C8H16) (de préférence lorsqu'il n'est pas utilisé comme composé « b »), cyclononane (C9H18), cyclodécane (C10H20) ;
- les hydrocarbures aromatiques ayant de 7 à 18 atomes de carbone dont on citera à titre illustratif les toluène, xylène, éthylbenzène, éthyltoluène ;
- et leurs mélanges.

Selon un mode d'exécution préféré de la présente invention, au moins un agent dispersant (le composé « c ») est également présent en addition du précurseur d'argent - et du solvant de synthèse (lorsque ce dernier est utilisé). Cet agent dispersant, que nous appellerons agent dispersant de synthèse correspond donc au composé « c » défini ci-dessous et est de préférence choisi parmi la liste des agents dispersants décrits ci-après dans la présente description.

Selon un mode d'exécution préféré de la présente invention, les nanoparticules d'argent sont donc synthétisées par synthèse chimique, par réduction du précurseur d'argent au moyen d'un agent réducteur en présence de l'agent dispersant de synthèse (le composé « c »), le tout s'effectuant de préférence dans le solvant de synthèse. Cette synthèse s'effectue de préférence dans des conditions de pression et de température non contraignantes telles que définies ci-après dans la présente description.

L'agent réducteur pourra être sélectionné parmi une large gamme de composés permettant la réduction du précurseur d'argent. On citera à titre illustratif les composés suivants : l'hydrogène ; les hydrures, parmi lesquels nous citerons à titre d'exemple les NaBH4, LiBH4, KBH4, et le borohydure de tétrabutylammonium ; les hydrazines, parmi lesquels nous citerons à titre d'exemple les hydrazine (H2N-NH2), hydrazine substituée (méthylhydrazine, phénylhydrazine, dimétylhydrazine, diphénylhydrazine, etc...), sel d'hydrazine (substituée), etc... ; les amines, parmi lesquels nous citerons à titre d'exemple les triméthylamine, triéthylamine, etc... ; et leurs mélanges.

En général, après l'étape de réduction, les nanoparticules sont ensuite soumises à une étape de lavage/purification qui permet d'éliminer tout ce qui n'est pas chimiquement ou physiquement lié aux nanoparticules.

Selon un mode d'exécution particulier de la présente invention, une phase liquide est toujours présente, à la fois lors de l'étape de réduction du précurseur d'argent ainsi que lors de toutes les étapes (par exemple les étapes de lavage et purification susmentionnées) qui précèdent l'ajout du composé « b ». En d'autres termes, une caractéristique préférée selon la présente invention consiste en ce que les nanoparticules d'argent ne soient jamais isolées et séchées ; elles restent donc de préférence toujours en contact avec une phase liquide (par exemple un solvant) dans laquelle elles sont dispersées. Comme démontré plus avant dans la description, cette caractéristique permet d'améliorer considérablement certaines propriétés (monodispersion, homogénéité, stabilité et recuit à plus basse température) des nanoparticules d'argent. Cette approche permet de supprimer l'étape d'isolation des nanoparticules ce qui a un impact positif en termes de coûts de production et d'hygiène et sécurité des personnes.

Selon une variante de réalisation de la présente invention, avant son utilisation dans la formulation de l'encre, le composé « a » est avantageusement dispersé dans un solvant de dispersion (composé « b » défini ci-dessous). Lorsque le solvant de dispersion est utilisé, le solvant de synthèse des nanoparticules cité ci-dessus est de préférence différent du dit solvant de dispersion. Le composé « b » selon la présente invention consiste de préférence en un solvant cyclooctane et/ou un solvant de type ester méthylique d'acides gras et/ou un solvant terpénique (de préférence sélectionné parmi les hydrocarbures et leurs dérivés aldéhydes, cétones et/ou acides terpéniques), et/ou un mélange de deux ou plusieurs des dits solvants.

Le solvant de type ester méthylique d'acides gras est de préférence à chaine hydrocarbonée courte ; par exemple une chaine comprenant entre 4 et 8 atomes de carbone. On citera à titre d'exemples les butanoate de méthyle, hexanoate de méthyle, et/ou octanoate de méthyle.

Le solvant terpénique est de préférence de type monoterpène. On citera à titre d'exemples les hydrocarbures ainsi que leurs dérivés (aldéhydes, cétones et acides) terpéniques, de préférence les hydrocarbures terpéniques. On citera aussi à titre d'exemples les limonène, menthol, menthone, camphre, nérol, myrcène, myrcénol, alphapinène, bétapinène, terpinéol, isobornéol, citronellol, linalol, et/ou géraniol. Selon un mode d'exécution particulier de la présente invention, les encres ne comprennent pas d'alcool de monoterpène.

Selon une variante de réalisation de la présente invention, un deuxième agent dispersant (appelé composé « d » ci-après) est également utilisé en complément des nanoparticules d'argent avant formulation de l'encre; de préférence, l'addition du deuxième agent dispersant (composé « d ») a lieu après la synthèse des nanoparticules, par exemple lors de l'étape de dispersion mentionnée ci-dessus. Les composés « c » (agent dispersant de synthèse) et « d » (agent dispersant de dispersion) selon la présente invention consistent donc en des agents dispersants caractérisés en ce que l'agent dispersant « d » est différent de l'agent « c » utilisé. Cette différence s'affiche par une chimie différente ; nous citerons à titre illustratif une longueur de chaine carbonée différente (par exemple une différence d'au moins deux atomes de carbone dans la chaine), et/ou un composé à chaine carbonée linéaire et l'autre pas, et/ou un composé à chaine carbonée cyclique et l'autre pas et/ou un composé à chaine carbonée aromatique et l'autre pas. Selon un mode d'exécution préféré de la présente invention, le composé « c » possède une masse moléculaire et/ou une longueur de chaine carbonée au moins 20% supérieure à celle du composé « d », par exemple au moins 40% supérieure.

Ces agents dispersants peuvent avantageusement être sélectionnés parmi les familles des agents dispersants organiques qui comprennent au moins un atome de carbone. Ces agents dispersants organiques peuvent aussi comprendre un ou plusieurs hétéroatomes non métalliques tels qu'un composé halogéné, l'azote, l'oxygène, le soufre, le silicium.

On citera à titre illustratif les thiols et leurs dérivés, les amines et leurs dérivés (par exemple les amino alcools et les éthers d'amino alcools), les acides carboxyliques et leurs dérivés carboxylates, les polyéthylène glycols, et/ou leurs mélanges.

Dans une variante de réalisation préférée de la présente invention, les agents dispersants organiques « c » et « d » seront sélectionnés dans le groupe constitué par les amines telles que par exemple la propylamine, la butylamine, la pentylamine, l'hexylamine, l'heptylamine, l'octylamine, la nonylamine, la décylamine, l'undécylamine, la dodécylamine, la tridécylamine, la tetradécylamine, l'hexadécylamine, le diaminopentane, le diaminohexane, le diaminoheptane, le diaminooctane, le diaminononane, le diaminodécane , la dipropylamine, la dibutylamine, la dipentylamine, la dihexylamine, la diheptylamine, la dioctylamine, la dinonylamine, la didécylamine, la méthylpropylamine, l'éthylpropylamine, la propylbutylamine, l'éthylbutylamine, l'éthylpentylamine, la propylpentylamine, la butylpentylamine, la tributylamine, la trihexylamine, ou leurs mélanges.

Selon un mode d'exécution préféré de la présente invention, les composés « b » et « d » sont rajoutés aux nanoparticules d'argent déjà synthétisées en présence du composé « c ».

Ce rajout se passe généralement après les étapes de lavage/purification des nanoparticules comme décrit dans la présente description.

Un exemple particulier de synthèse de nanoparticules et de préparation de la dispersion correspondante selon un mode d'exécution préféré de la présente invention est décrit à titre illustratif ci-après :
Préparation de la dispersion des nanoparticules dans le solvant « b » :
Dans un réacteur contenant de l'acétate d'argent dans le toluène, l'agent dispersant de synthèse (composé « c » ; par exemple la dodécylamine) est ajoutée et le mélange est agité moins de 30 minutes à 65°C. L'agent réducteur hydrazine est ensuite ajouté rapidement au mélange et l'ensemble est laissé sous agitation environ 60 minutes. Le mélange est traité par l'ajout de méthanol (ou de tout autre solvant approprié, par exemple un autre alcool monohydrique ayant de 2 à 3 atomes de carbone, par exemple de l'éthanol) et le surnageant est éliminé au cours de trois lavages successifs (les nanoparticules d'argent ainsi formées restent donc à l'état de dispersion et au contact de liquide, en l'occurrence au contact de méthanol). Le solvant cyclooctane (composé « b ») est ajouté et le méthanol résiduel est évaporé. Le composé « d » (un agent dispersant différent du composé « b » utilisé - par exemple une octylamine) est ensuite ajouté et le mélange est agité pendant 15 minutes à température ambiante. Les nanoparticules d'argent ainsi obtenues en dispersion sont utilisées directement pour la formulation des encres conductrices.

Ainsi, les nanoparticules qui sont utilisées selon la présente invention sont caractérisées par des valeurs de D50 qui sont préférentiellement comprises entre 2 et 12 nm.

Pour les nanoparticules synthétisées en présence de solvant la gamme préférée de D50 sera entre 2 et 8 nm ; pour les nanoparticules synthétisées en absence de solvant la gamme préférée de D50 sera entre 5 et 12 nm.

La dispersion ainsi obtenue pourra être utilisée directement ou bien diluée afin d'obtenir les propriétés souhaitées avant d'être incorporée dans l'encre. Toutefois, et ceci représente un avantage considérable des dispersions selon la présente invention, les dites dispersions sont caractérisées par une stabilité supérieure (avant dilution) comme démontrée dans les exemples.

Selon une variante de réalisation de la présente invention, les encres comprennent en plus du composé nanoparticules d'argent « a », au moins un composé agent dispersant « c » et au moins un composé agent dispersant « d » différent du composé « c », ainsi qu'un composé solvant de dispersion optionnel « b ». Ainsi, selon un mode d'exécution préféré de la présente invention, les nanoparticules utilisées dans la formulation de l'encre se trouvent sous la forme d'une dispersion comprenant
- un composé « a » dans une teneur supérieure à 30 % en poids, de préférence supérieure à 35 % en poids, par exemple supérieure à 40 % en poids,
- un composé « b » optionnel dans une teneur inférieure ou égale à 65% en poids, de préférence comprise entre 20 et 65 % en poids, de préférence entre 40 et 60 % en poids,
- un composé « c » dans une teneur comprise entre 3 et 15 % en poids, de préférence entre 3 et 10 % en poids, et
- un composé « d » dans une teneur comprise entre 0,1 et 15 % en poids, de préférence entre 0,4 et 5 % en poids.

Le composé « e » présent dans l'encre selon la présente invention consiste donc en un solvant. Selon la variante de réalisation selon la présente invention qui utilise un solvant de dispersion (composé « b » cyclooctane et/ou ester méthylique d'acides gras et/ou solvant terpénique), le composé « e » contient au moins un solvant différent du composé « b » utilisé.

Ce composé solvant « e » est de préférence caractérisé par un point d'ébullition inférieure à 260°C et, lorsqu'un solvant de dispersion est utilisé, une polarité plus élevée que le dit solvant de dispersion. Il appartient de préférence à la catégorie des alcools et/ou des dérivés d'alcools (par exemple les éthers de glycol). On citera à titre d'exemples les alcools monohydriques (par exemple les isopropanol, butanol, pentanol, hexanol,....) et/ou les glycols (par exemple les ethylène glycol, propylène glycol, diethylène glycol.....), et/ou les éthers de glycols (par exemple les mono- ou di-éthers de glycols parmi lesquels nous citerons à titre d'exemple les éthylène glycol propyl éther, éthylène glycol butyle éther, éthylène glycol phényl éther, di éthylène glycol méthyl éther, di éthylène glycol éthyle éther, di éthylène glycol propyl éther, di éthylène glycol butyle éther, propylène glycol méthyle éther, propylène glycol butyle éther, propylène glycol propyl éther, éthylène glycol di-méthyl éther, éthylène glycol di-éthyle éther, éthylène glycol di-butyle éther, glymes, éther di éthylique de di éthylène-glycol, éther di éthylique de di butylène-glycol, diglymes, éthyle diglyme, butyle diglyme), et/ou les acétates d'éther de glycols (par exemple, les acétate de 2-Butoxyéthyle, di éthylène glycol monoethyl éther acétate, di éthylène glycol butylether acétate, propylène glycol méthyle éther acétate), et/ou un mélange de deux ou plusieurs des dits solvants précités.

Le composé « f » selon la présente invention consiste donc en un agent modificateur de rhéologie sélectionné parmi les agents modificateurs de rhéologie de type urée. Il est sélectionné parmi les urées modifiées, les polyurées, et/ou leurs mélanges.

Le composé « g » selon la présente invention consiste donc en un agent modificateur de rhéologie sélectionné parmi les agents modificateur de rhéologie de type cellulosique. On citera à titre d'exemple les alkyle-cellulose, de préférence l'éthylcellulose, les nitrocelluloses et/ou leurs mélanges.

Selon un mode d'exécution particulier de la présente invention, les compositions d'encres peuvent également comprendre un solvant additionnel, que nous appellerons solvant « X » et qui pourra être avantageusement sélectionné parmi un ou plusieurs des solvants de synthèse des nanoparticules et/ou des solvants « b » de dispersion précités et/ou un mélange de deux ou plusieurs des dits solvants. Selon une variante de réalisation de la présente invention, le dit solvant « X » comprendra (ou sera avantageusement sélectionné) parmi les alcanes et/ou leurs mélanges.

Un exemple particulier de préparation de l'encre selon la présente invention est décrit à titre illustratif ci-après :
Dans un réacteur on prépare un mélange de solvant « e » et de composé « g » (par exemple éther(s) de glycol et nitrocellulose) ; on y ajoute respectivement et dans l'ordre le solvant « X » optionnel (par exemple du cyclooctane et/ou un mélange d'alcanes), le composé « f » optionnel (agent modificateur de rhéologie de type urée), et le composé « a » (de préférence sous la forme d'une dispersion de nanoparticules d'argent).

Selon un mode d'exécution particulier de la présente invention, les encres formulées selon la présente invention contiennent une teneur inférieure à 60% en poids de nanoparticules (composé « a »), de préférence entre 5 et 45%, et plus particulièrement entre 10 et 40% en poids.

Selon un mode d'exécution de la présente invention, l'encre d'argent comprend
- un composé « a » dans une teneur inférieure à 60 % en poids,
- un composé « e » dans une teneur comprise entre 1 et 60 % en poids, de préférence entre 20 et 55 % en poids, et
- un composé « f » et/ou « g » dans une teneur inférieure à 20 % en poids, de préférence entre 0,1 et 15 % en poids, et
- un composé « X » optionnel dans une teneur inférieure à 40 % en poids, de préférence entre 0,1 et 30 % en poids.

Selon une variante de réalisation de la présente invention, lorsque le composé « a » est compris dans une dispersion conforme à la présente invention (avec les composés « a », optionnel « b », « c » et « d » cités ci-dessus), l'encre d'argent comprend
- une dispersion conforme à la présente invention (avec les composés « a », « b » optionnel, « c » et « d »), dans une teneur inférieure à 60 % en poids, et de préférence supérieure à 5 % en poids, de préférence supérieure à 10 % en poids, par exemple supérieure à 20 % en poids et même supérieure à 40 % en poids,
- un composé « e » dans une teneur comprise entre 1 et 60 % en poids, de préférence entre 20 et 55 % en poids, et
- un composé « f » et/ou « g » dans une teneur inférieure à 20 % en poids, de préférence entre 0,1 et 15 % en poids, et
- un composé « X » optionnel dans une teneur inférieure à 40 % en poids, de préférence entre 0,1 et 30 % en poids, par exemple supérieure à 10% en poids.

Selon un mode d'exécution de la présente invention, lorsque le composé « f » est présent dans la formulation d'encre, sa teneur est comprise entre 0,1 et 2 % en poids.

Selon un mode d'exécution de la présente invention, lorsque le composé « g » est présent dans la formulation d'encre, sa teneur est de préférence comprise entre 3 et 10 % en poids.

Selon un mode d'exécution de la présente invention, l'encre peut également intégrer dans sa composition d'autres composés parmi lesquels nous citerons à titre d'exemple des additifs (par exemple, un additif de la famille des silanes) dont l'objectif est d'améliorer la tenue à différents type de stress mécanique, par exemple l'adhérence sur de nombreux substrats ; on pourra citer à titre d'illustration les substrats suivants polyimide, polycarbonate, polyethertetphtalate PET), polyéthylène naphthalate (PEN), polyaryléthercétone, polyester, polyester thermostabilisé, verre, verre ITO, verre AZO, verre SiN.

Toutefois, les composés « a », « b », « c », « d », « e », « f », « g » et « X » (dans les gammes de proportions indiquées ci-dessus) constitueront de préférence au moins 95% en poids, au moins 99% en poids, ou même 100% en poids de l'encre finale.

Selon un mode d'exécution de la présente invention, l'encre n'intègre pas d'alcool ayant de 10 à 18 atomes de carbone.

Selon un mode d'exécution de la présente invention, l'encre n'intègre pas d'eau dans sa composition. Toutefois, comme les composants de l'encre peuvent tolérer des traces d'eau en fonction de leur degré de pureté, il va de soi que la somme de ces traces d'eau correspondantes seront acceptables dans les encres selon la présente invention. Ainsi, la teneur en eau dans l'encre finale dépend en général essentiellement de la teneur en eau des solvants utilisés pour sa préparation ; l'alcool monohydrique (le méthanol de lavage de la dispersion dans notre exemple de réalisation ci-dessus) aura à ce citre l'impact le plus important - par comparaison avec les autres solvants utilisés lors de la préparation de l'encre - sur la teneur finale en eau de l'encre. Selon la présente invention, les encres comprennent des concentrations en eau inférieures à 2 % en poids, de préférence inférieures à 1% en poids, par exemple inférieures à 0,5% en poids, ou même inférieures à 0,2% en poids.

Selon un mode d'exécution préféré de la présente invention, à l'exception des traces d'eau éventuellement présentes dans les composés de formulation/préparation de l'encre, de l'eau n'est pas ajoutée lors de la formulation des encres.

Selon une variante de réalisation de la présente invention, la préparation de la dispersion de nanoparticules selon la présente invention est caractérisée par les étapes suivantes :
a. synthèse des nanoparticules d'argent en présence de l'agent dispersant (composé « c » ) par réduction au moyen d'un agent réducteur d'un précurseur d'argent ;
b. lavage/purification des nanoparticules obtenues à l'étape « a »,
c. addition du composé « b » et du composé « d ».

Selon une variante de réalisation préférée de la présente invention, une phase liquide est toujours présente lors de toutes ces étapes de préparation. En d'autres termes, une caractéristique préférée selon la présente invention consiste en ce que les nanoparticules d'argent ne soient jamais isolées et séchées ; elles restent donc de préférence toujours en contact avec une phase liquide (par exemple un solvant) dans laquelle elles sont dispersées.

Selon une variante de réalisation préférée de la présente invention, lors de l'étape « a », l'addition de l'agent réducteur s'effectue dans tout récipient adapté (par exemple un réacteur) avec la caractéristique qu'elle s'effectue sous-niveau, par exemple à l'aide d'un plongeur directement introduit dans le milieu réactionnel.

Un avantage additionnel de la dispersion selon la présente invention réside dans le fait que sa préparation peut être effectuée à des conditions de pression et/ou de température non contraignantes, par exemple à des conditions de pression et/ou de température proches aux conditions normales ou ambiantes. Il est préférable de rester à moins de 40% des conditions normales ou ambiantes de pression et, en ce qui concerne la température, cette dernière est généralement inférieure à 80°C, de préférence inférieure à 70°C. Par exemple, la Demanderesse a constaté qu'il était préférable de maintenir les conditions de pression durant la préparation de la dispersion à des valeurs oscillant au maximum de 30%, de préférence de 15% autour des valeurs des conditions de pression normales ou ambiantes, de préférence proche de la pression atmosphérique. Un contrôle de ces conditions de pression et/ou de température peut donc être avantageusement inclus dans le dispositif de préparation de la dispersion de manière à remplir ces conditions. Cet avantage lié à une préparation de la dispersion dans des conditions non contraignantes se traduit bien évidemment également par une utilisation facilitée des dites dispersions.

Selon une variante de réalisation de la présente invention, la préparation de l'encre à base de nanoparticules selon la présente invention est caractérisée par les étapes consécutives suivantes :
a. introduction du composé « e » dans un récipient,
b. addition du composé « g »,
c. addition du solvant X si présent,
d. addition du composé « f » si présent,
e. addition du composé « a » et/ou de la dispersion selon la présente invention.

L'encre ainsi obtenue pourra être utilisée directement ou bien diluée afin d'obtenir les propriétés souhaitées.

Un avantage additionnel de l'encre selon la présente invention réside dans le fait que sa préparation peut être effectuée à des conditions de pression et/ou de température non contraignantes, par exemple à des conditions de pression et/ou de température proches ou identiques aux conditions normales ou ambiantes. Il est préférable de rester à moins de 40% des conditions normales ou ambiantes de pression et/ou de température. Par exemple, la Demanderesse a constaté qu'il était préférable de maintenir les conditions de pression et/ou de température durant la préparation de l'encre à des valeurs oscillant au maximum de 30%, de préférence de 15% autour des valeurs des conditions normales ou ambiantes. Un contrôle de ces conditions de pression et/ou de température peut donc être avantageusement inclus dans le dispositif de préparation de l'encre de manière à remplir ces conditions. Cet avantage lié à une préparation de l'encre dans des conditions non contraignantes se traduit bien évidemment également par une utilisation facilitée des dites encres.

Selon un mode d'exécution de la présente invention, l'encre peut avantageusement être utilisée en sérigraphie.

Il est donc évident pour l'homme de l'art que la présente invention permet des modes de réalisation sous de nombreuses autres formes spécifiques sans pour autant s'éloigner du domaine d'application de l'invention tel que revendiqué. Par conséquent, les présents modes de réalisation doivent être considérés à titre d'illustration mais peuvent être modifiés dans le domaine défini par la portée des revendications jointes.

La présente invention et ses avantages seront à présent illustrés au moyen des formulations reprises dans le tableau ci-dessous. La synthèse des dispersions (en présence de solvant de synthèse - du toluène) et les formulations d'encres ont été préparées conformément aux modes d'exécution préférés décrits ci-dessus dans la description. Les composés chimiques utilisés sont indiqués dans la deuxième colonne du tableau.

La résistance carrée de l'encre telle que mentionnée dans la présente invention pourra être mesurée selon toute méthode appropriée. A titre d'exemple correspondant aux mesures reprises dans le tableau, elle peut être avantageusement mesurée selon la méthode suivante :
Une encre déposée par spincoater sur un substrat (600 ou 1000 tour minute / 1 ou 3 min - par exemple du verre), est soumise à un recuit à l'aide d'une plaque chauffante ou d'un four (250°C - 10min). Une analyse de la résistance carrée est réalisée dans les conditions suivantes :
Référence de l'appareil : S302 Resistivity Stand
Référence tête 4 pointes : SP4-40045TFY
Référence source de courant : Agilent U8001A
Référence multimètre : Agilent U3400
Température de mesure : température ambiante
Coefficient conversion tension/résistance : 4.5324
   • Exemple 1(formulation 1 du tableau ci-dessous) : 230 mohms/sq pour une épaisseur de 1.3 µm sur polyimide ou verre - 250°C/10 min.

Selon une variante de réalisation de la présente invention, la Demanderesse a découvert que les valeurs de résistance carrée (mesurée comme décrit ci-dessus) des encres obtenues conformément à la présente invention étaient de préférence inférieures à 300 mohms/sq pour des épaisseurs supérieures ou égales à 1 µm (température de recuit de 250°C); et en particulier pour des encres présentant une gamme de viscosités convenant au domaine de la sérigraphie. Cette propriété particulière de résistance carrée confère aux encres de la présente invention une conductivité améliorée pour des températures de recuit inférieures généralement comprises entre 200°C et 300°C (comme démontré dans l'exemple et la mesure).

La teneur en nanoparticules d'argent telle que mentionnée dans la présente invention pourra être mesurée selon toute mesure appropriée. A titre d'exemple correspondant aux mesures reprises dans le tableau, elle peut être avantageusement mesurée selon la méthode suivante :
Analyse thermogravimétrique
Appareil : TGA Q50 de TA Instrument
Creuset : Alumine
Méthode : rampe
Plage de mesure : de température ambiante à 600°C
Montée en température : 10°C/min

La distribution des tailles des nanoparticules d'argent (dans la dispersion D50) telle que mentionnée dans la présente invention pourra être mesurée selon toute méthode appropriée. A titre d'exemple, elle peut être avantageusement mesurée selon la méthode suivante : utilisation d'un appareil de type Nanosizer S de Malvern avec les caractéristiques suivantes :
Méthode de mesure DLS (Dynamic light scattering) :
- Type de cuve : verre optique
- Matériel : Ag
- Indice de réfraction des nanoparticules : 0.54
- Absorption : 0.001
- Dispersant : Cyclooctane
- Température : 20 °C
- Viscosité : 2.133
- Indice de réfraction dispersant : 1.458
- General Options : Mark-Houwink parameters
- Analysis Model : General purpose
- Equilibration : 120 s
- Nombre de mesure : 4

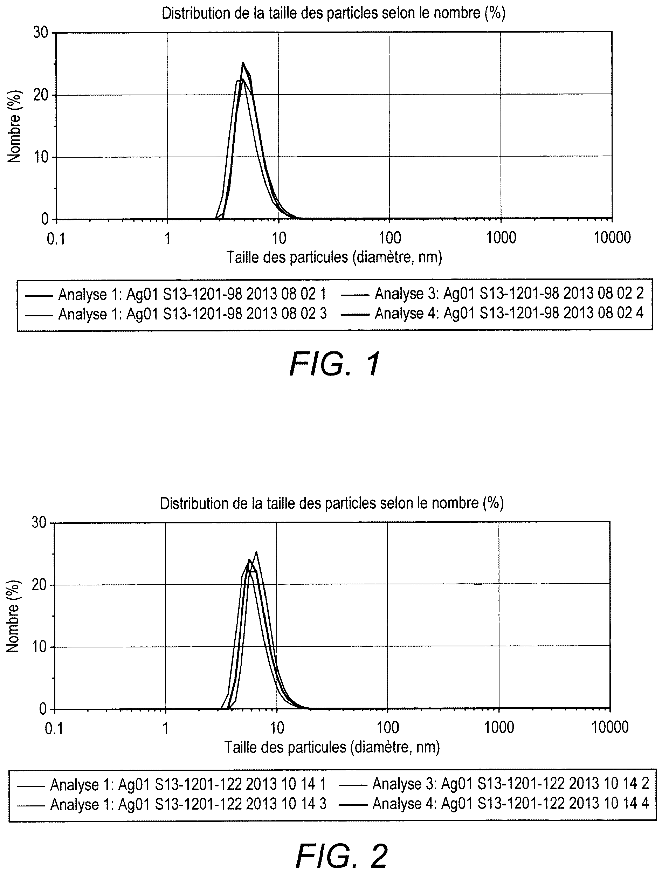

Les figures 1 et 2 sont représentatives d'exemple général de spectre DLS (Dynamic light scattering) obtenu lors de la synthèse des nanoparticules selon la présente invention respectivement avec solvant de synthèse (figure 1) et sans solvant de synthèse (figure 2). On peut y voir les spectres granulométriques en nombre de la taille (en nm) des nanoparticules d'argent.
Figure 1 - D50 : 5,6 nm
Figure 2 - D50 : 8,0 nm
   D50 est le diamètre pour lequel 50% des nanoparticules d'argent en nombre sont plus petits. Cette valeur est considérée comme représentative de la taille moyenne des grains.

La viscosité de l'encre telle que mentionnée dans la présente invention pourra être mesurée selon toute méthode appropriée. A titre d'exemple, elle peut être avantageusement mesurée selon la méthode suivante :
Appareil : Rhéomètre AR-G2 de TA Instrument
Temps de conditionnement : 1 minute pour les formulations 1, 2 et 3 et 30 minutes pour la formulation 4
Type de test : Rampe continue
Rampe : Vitesse de cisaillement (1/s)
De : 0.001 à 40 (1/s)
Durée : 5 minutes
Mode : linéaire
Mesure : toutes les 10 secondes
Température : 20°C
Méthode de retraitement de la courbe : Newtonien
Zone retraitée : toute la courbe

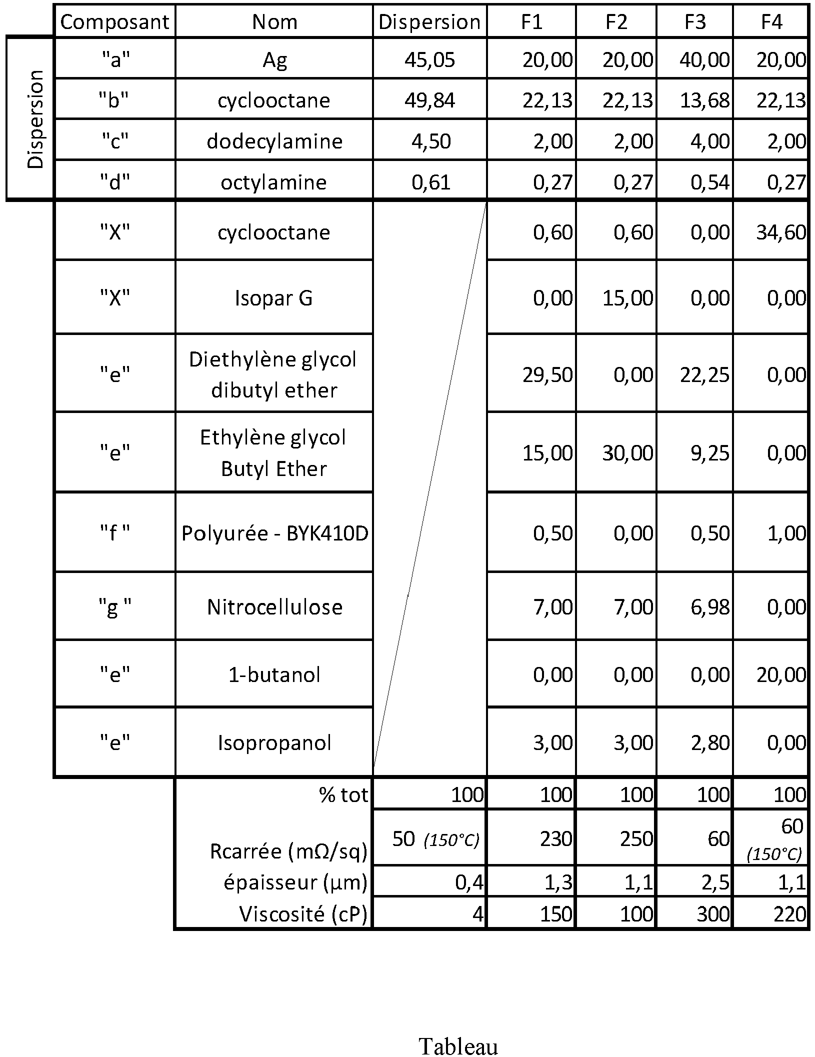

## Revendications

1. Composition d'encre à base de nanoparticules d'argent comprenant
1. un composé « a » consistant en des nanoparticules d'argent de forme sphéroïdale et/ou sphérique et de diamètres compris entre 1 et 50 nm,
2. un composé « e » consistant en un solvant, et
3. au moins un composé « f » et/ou « g » sélectionné parmi
a. un composé « f » consistant en un agent modificateur de rhéologie de type polyurée dont la teneur est comprise entre 0,1 et 2 % en poids, et
b. un composé « g » consistant en un agent modificateur de rhéologie de type cellulosique.
4. un composé « c » optionnel consistant en un agent dispersant,
5. un composé « d » optionnel consistant en un agent dispersant différent du composé « c »,
6. un composé optionnel « b » consistant en un solvant cyclooctane et/ou un solvant de type ester méthylique d'acides gras et/ou un solvant terpénique, et/ou un mélange de deux ou plusieurs des dits solvants, et
7. un solvant « X » optionnel additionnel de préférence sélectionné parmi les alcanes et/ou leurs mélanges,
**caractérisé en ce que** les composés « a », « b », « c », « d », « e », « f », « g » et « X » constituent au moins 95% en poids de la composition d'encre, **en ce qu'**elle comprend une teneur en eau inférieure à 2 % en poids et **en ce que** la viscosité à 20°C de l'encre est comprise entre 100 et 1000 mPa.s.

2. Composition d'encre selon la revendication précédente **caractérisée en ce que** la viscosité à 20°C de l'encre est comprise entre 100 et 800 mPa.s.

3. Composition d'encre selon l'une quelconque des revendications précédentes **caractérisée en ce que** le composé « e » est sélectionné parmi la famille des alcools et/ou des dérivés d'alcools.

4. Composition d'encre selon la revendication précédente **caractérisée en ce que** le composé « e » est sélectionné parmi les éthers de glycols, par exemple les mono- ou di-éthers de glycols.

5. Composition d'encre selon l'une quelconque des revendications précédentes **caractérisée en ce qu'**elle comprend
• un composé « a » dans une teneur inférieure à 60 % en poids,
• un composé « e » dans une teneur comprise entre 1 et 60 % en poids, de préférence entre 20 et 55 % en poids, et
• un composé « f », ou un composé « f » et un composé « g » dans une teneur inférieure à 20 % en poids, de préférence entre 0,1 et 15 % en poids, et
• un composé solvant « X » optionnel constitué d'alcanes et/ou de mélanges d'alcanes dans une teneur inférieure à 40 % en poids, de préférence entre 0,1 et 30 % en poids.

6. Composition d'encre selon l'une quelconque des revendications précédentes **caractérisée en ce qu'**elle comprend le composé « f » dans une teneur comprise entre 0,1 et 2 % en poids et le composé « g » dans une teneur comprise entre 3 et 10 % en poids.

7. Composition d'encre selon l'une quelconque des revendications précédentes **caractérisée en ce qu'**elle comprend
1. un composé « c » consistant en un agent dispersant,
2. un composé « d » consistant en un agent dispersant différent du composé « c », et
3. un composé optionnel « b » consistant en un solvant cyclooctane et/ou un solvant de type ester méthylique d'acides gras et/ou un solvant terpénique, et/ou un mélange de deux ou plusieurs des dits solvants.

8. Composition d'encre selon la revendication précédente **caractérisée en ce que** les composés « a », optionnel « b », « c » et « d » forment une dispersion de nanoparticules d'argent et que la composition d'encre comprend
• la dite dispersion dans une teneur inférieure à 60 % en poids, et de préférence supérieure à 5 % en poids, de préférence supérieure à 10 % en poids, par exemple supérieure à 20 % en poids et même supérieure à 40 % en poids,
• un composé « e » dans une teneur comprise entre 1 et 60 % en poids, de préférence entre 20 et 55 % en poids, et
• un composé « f », ou un composé « f » et un composé « g » dans une teneur inférieure à 20 % en poids, de préférence entre 0,1 et 15 % en poids, et
• un composé solvant « X » optionnel dans une teneur inférieure à 40 % en poids, de préférence entre 0,1 et 30 % en poids, par exemple supérieure à 10% en poids.

9. Composition d'encre selon l'une quelconque des revendications précédentes **caractérisée en ce que** leur valeur de propriété de résistance carrée est inférieure à 300 mohms/sq pour des épaisseurs supérieures ou égales à 1 µm (température de recuit de 250°C).

10. Composition d'encre selon l'une quelconque des revendications précédentes **caractérisée en ce qu'**elle comprend une teneur en eau inférieure à 1% en poids, par exemple inférieure à 0,5% en poids, ou même inférieure à 0,2% en poids.

11. Composition d'encre selon l'une quelconque des revendications précédentes **caractérisée en ce que** les nanoparticules d'argent (composé « a ») ont des valeurs de D50 comprises entre 2 et 12 nm.

12. Utilisation d'une encre selon l'une quelconque des revendications précédentes en sérigraphie.

## Patentansprüche

1. Druckfarbenzusammensetzung auf Basis von Silbernanopartikeln, umfassend
1. eine Verbindung "a", die in Silbernanopartikeln mit kugelähnlicher und/oder kugelrunder Form und Durchmessern im Bereich von 1 bis 50 nm besteht,
2. eine Verbindung "e", die in einem Lösungsmittel besteht, und
3. mindestens eine Verbindung "f" und/oder "g", die aus den folgenden ausgewählt ist
a. einer Verbindung "f", die in einem Rheologiemodifizierer vom Typ Polyharnstoff besteht, dessen Gehalt im Bereich von 0,1 bis 2 Gewichts-% liegt, und
b. einer Verbindung "g", die in einem Rheologiemodifizierer vom celluloseartigen Typ besteht.
4. eine optionale Verbindung "c", die in einem Dispergiermittel besteht,
5. eine optionale Verbindung "d", die in einem Dispergiermittel besteht, welches sich von der Verbindung "c" unterscheidet,
6. eine optionale Verbindung "b", die in einem Cyclooctan-Lösungsmittel und/oder einem Lösungsmittel vom Typ Fettsäuremethylester und/oder einem terpenartigen Lösungsmittel und/oder einer Mischung aus zweien oder mehreren dieser Lösungsmittel besteht, und
7. ein zusätzliches optionales Lösungsmittel "X", das vorzugsweise aus den Alkanen und/oder deren Mischungen ausgewählt ist,
**dadurch gekennzeichnet, dass** die Verbindungen "a", "b", "c", "d", "e", "f", "g" und "X" mindestens 95 Gewichts-% der Druckfarbenzusammensetzung ausmachen, dadurch, dass sie einen Wassergehalt von weniger als 2 Gewichts-% umfasst, und dadurch, dass Druckfarbe bei 20 °C die Viskosität im Bereich von 100 bis 1.000 mPa.s hat.

2. Druckfarbenzusammensetzung nach einem beliebigen der vorhergehenden Ansprüche, **dadurch gekennzeichnet, dass** die Druckfarbe bei 20 °C eine Viskosität im Bereich von 100 bis 800 mPa.s hat.

3. Druckfarbenzusammensetzung nach einem beliebigen der vorhergehenden Ansprüche, **dadurch gekennzeichnet, dass** die Verbindung "e" aus der Familie der Alkohole und/oder der Alkoholderivate ausgewählt ist.

4. Druckfarbenzusammensetzung nach dem vorhergehenden Anspruch, **dadurch gekennzeichnet, dass** die Verbindung "e" aus den Glykolethern, beispielsweise den Mono- oder Diethern von Glykolen ausgewählt ist.

5. Druckfarbenzusammensetzung nach einem beliebigen der vorhergehenden Ansprüche, **dadurch gekennzeichnet, dass** sie Folgendes umfasst:
• eine Verbindung "a" zu einem Gehalt von weniger als 60 Gewichts-%,
• eine Verbindung "e" zu einem Gehalt im Bereich von 1 bis 60 Gewichts-%, vorzugsweise im Bereich von 20 bis 55 Gewichts-%, und
• eine Verbindung "f", oder eine Verbindung "f" und eine Verbindung "g", zu einem Gehalt von weniger als 20 Gewichts-%, vorzugsweise im Bereich von 0,1 bis 15 Gewichts-%, und
• eine optionale Lösungsmittelverbindung "X", die aus Alkanen und/oder Alkanmischungen besteht, zu einem Gehalt von weniger als 40 Gewichts-%, vorzugsweise im Bereich von 0,1 bis 30 Gewichts-%.

6. Druckfarbenzusammensetzung nach einem beliebigen der vorhergehenden Ansprüche, **dadurch gekennzeichnet, dass** sie die Verbindung "f" zu einem Gehalt im Bereich von 0,1 bis 2 Gewichts-% und die Verbindung "g" zu einem Gehalt im Bereich von 3 bis 10 Gewichts-% umfasst.

7. Druckfarbenzusammensetzung nach einem beliebigen der vorhergehenden Ansprüche, **dadurch gekennzeichnet, dass** sie Folgendes umfasst:
1. eine Verbindung "c", die in einem Dispergiermittel besteht,
2. eine Verbindung "d", die in einem Dispergiermittel besteht, welches sich von der Verbindung "c" unterscheidet, und
3. eine optionale Verbindung "b", die in einem Cyclooctan-Lösungsmittel und/oder einem Lösungsmittel vom Typ Fettsäuremethylester und/oder einem terpenartigen Lösungsmittel und/oder einer Mischung aus zweien oder mehreren dieser Lösungsmittel besteht.

8. Druckfarbenzusammensetzung nach dem vorhergehenden Anspruch, **dadurch gekennzeichnet, dass** die Verbindung "a", die optionale Verbindung "b" sowie Verbindungen "c" und "d" eine Dispersion von Silbernanopartikeln bilden und dass die Druckfarbenzusammensetzung Folgendes umfasst
• ebendiese Dispersion zu einem Gehalt von weniger als 60 Gewichts-%, und vorzugsweise von mehr als 5 Gewichts-%, vorzugsweise von mehr als 10 Gewichts-%, beispielsweise von mehr als 20 Gewichts-% oder sogar von mehr als 40 Gewichts-%,
• eine Verbindung "e" zu einem Gehalt im Bereich von 1 bis 60 Gewichts-%, vorzugsweise im Bereich von 20 bis 55 Gewichts-%, und
• eine Verbindung "f", oder eine Verbindung "f" und eine Verbindung "g", zu einem Gehalt von weniger als 20 Gewichts-%, vorzugsweise im Bereich von 0,1 bis 15 Gewichts-%, und
• eine optionale Lösungsmittelverbindung "X" zu einem Gehalt von weniger als 40 Gewichts-%, vorzugsweise zwischen 0,1 und 30 Gewichts-%, beispielsweise von mehr als 10 Gewichts-%.

9. Druckfarbenzusammensetzung nach einem beliebigen der vorhergehenden Ansprüche, **dadurch gekennzeichnet, dass** ihr Eigenschaftswert des Flächenwiderstands weniger als 300 mohm/sq bei Dickewerten von mindestens 1 µm (Wärmebehandlungstemperatur von 250 °C) beträgt.

10. Druckfarbenzusammensetzung nach einem beliebigen der vorhergehenden Ansprüche, **dadurch gekennzeichnet, dass** sie einen Wassergehalt von weniger als 1 Gewichts-%, beispielsweise von weniger als 0,5 Gewichts-%, oder sogar von weniger als 0,2 Gewichts-% umfasst.

11. Druckfarbenzusammensetzung nach einem beliebigen der vorhergehenden Ansprüche, **dadurch gekennzeichnet, dass** die Silbernanopartikel (Verbindung "a") D50-Werte im Bereich von 2 bis 12 nm haben.

12. Verwendung einer Druckfarbe nach einem beliebigen der vorhergehenden Ansprüche im Siebdruck.

## Claims

1. Ink composition based on silver nanoparticles comprising:
1. a compound "a" consisting of silver nanoparticles of spheroidal and/or spherical shape and having diameters between 1 and 50 nm,
2. a compound "e" consisting of a solvent, and
3. at least one compound "f" and/or "g" selected from
a. a compound "f" consisting of a rheology modifier of polyurea type the content of which is between 0.1 and 2% by weight, and
b. a compound "g" consisting of a rheology modifier of cellulose type,
4. an optional compound "c" consisting of a dispersant,
5. an optional compound "d" consisting of a dispersant different from compound "c",
6. an optional compound "b" consisting of a cyclooctane solvent and/or a solvent of fatty acid methyl ester type and/or a terpene solvent, and/or a mixture of two or more of said solvents, and
7. an additional optional solvent "X" preferably selected from alkanes and/or mixtures thereof, **characterized in that** the compounds "a", "b", "c", "d", "e", "f", "g" and "X" constitute at least 95% by weight of the ink composition, **in that** it comprises a water content of less than 2% by weight and **in that** the viscosity at 20°C of the ink is between 100 and 1000 mPa.s.

2. Ink composition according to the preceding claim, **characterized in that** the viscosity at 20°C of the ink is between 100 and 800 mPa.s.

3. Ink composition according to either one of the preceding claims, **characterized in that** the compound "e" is selected from the family of alcohols and/or derivatives of alcohols.

4. Ink composition according to the preceding claim, **characterized in that** the compound "e" is selected from glycol ethers, for example glycol mono- or diethers.

5. Ink composition according to any one of the preceding claims, **characterized in that** it comprises:
• a compound "a" in a content less than 60% by weight;
• a compound "e" in a content between 1 and 60% by weight, preferably between 20 and 55% by weight;
• a compound "f", or a compound "f" and a compound "g", in a content of less than 20% by weight, preferably between 0.1 and 15% by weight, and
• an optional solvent compound "X" consisting of alkanes and/or mixtures of alkanes in a content of less than 40% by weight, preferably between 0.1 and 30% by weight.

6. Ink composition according to any one of the preceding claims, **characterized in that** it comprises the compound "f" in a content between 0.1 and 2% by weight and the compound "g" in a content between 3 and 10% by weight.

7. Ink composition according to any one of the preceding claims, **characterized in that** it comprises:
1. a compound "c" consisting of a dispersant,
2. a compound "d" consisting of a dispersant different from the compound "c", and
3. an optional compound "b" consisting of a cyclooctane solvent and/or a solvent of fatty acid methyl ester type and/or a terpene solvent, and/or a mixture of two or more of said solvents.

8. Ink composition according to the preceding claims, **characterized in that** the compound "a," optional compound "b," and compounds "c" and "d" form a dispersion of silver nanoparticles and that the ink composition comprises:
• said dispersion in a content of less than 60% by weight, and preferably greater than 5% by weight, preferably greater than 10% by weight, for example greater than 20% by weight and even greater than 40% by weight,
• a compound "e" in a content of between 1 and 60% by weight, preferably between 20 and 55% by weight, and
• a compound "f", or a compound "f" and a compound "g", in a content of less than 20% by weight, preferably between 0.1 and 15% by weight, and
• an optional solvent compound "X" in a content of less than 40% by weight, preferably between 0.1 and 30% by weight, for example greater than 10% by weight.

9. Ink composition according to any one of the preceding claims, **characterized in that** their sheet resistance property value is less than 300 mohm/sq for thicknesses of greater than or equal to 1 µm (annealing temperature of 250°C).

10. Ink composition according to any one of the preceding claims, **characterized in that** it comprises a water content of less than 1% by weight, for example less than 0.5% by weight, or even less than 0.2% by weight.

11. Ink composition according to any one of the preceding claims, **characterized in that** the silver nanoparticles (compound "a") have D50 values of between 2 and 12 nm.

12. Use of an ink according to any one of the preceding claims in screen printing.
